Europäisches Patentamt

European Patent Office

Office européen des brevets

(19)

(11) **EP 1 677 423 A1**

(12) **EUROPEAN PATENT APPLICATION**
published in accordance with Art. 158(3) EPC

(43) Date of publication:
05.07.2006 Bulletin 2006/27

(51) Int Cl.:
*H03M 13/29* (2000.01)

(21) Application number: 04819763.6

(22) Date of filing: 19.11.2004

(86) International application number:
**PCT/JP2004/017284**

(87) International publication number:
**WO 2005/055433 (16.06.2005 Gazette 2005/24)**

(84) Designated Contracting States:
**DE FR GB**

(30) Priority: 01.12.2003 JP 2003402218

(71) Applicant: **MATSUSHITA ELECTRIC INDUSTRIAL CO., LTD.**
**Kadoma-shi, Osaka 571-8501 (JP)**

(72) Inventor: **LI, Jifeng**
**Matsushita Electric Industrial Co., Ltd**
**Osaka-shi, Osaka 540-6319 (JP)**

(74) Representative: **Grünecker, Kinkeldey,**
**Stockmair & Schwanhäusser**
**Anwaltssozietät**
**Maximilianstrasse 58**
**80538 München (DE)**

(54) **DECODER APPARATUS AND DECODING METHOD**

(57) A decoding apparatus is disclosed that is capable of reducing the calculation amount and memory capacity and preventing deterioration of characteristics at high decodingrates. In this decoding apparatus, a transition probability calculation section (201) calculates the transition probability from systematic bit Y1, parity bit Y2 and a priori value La1, and a forward probability calculation section (202) divides a data sequence into a plurality of windows and calculates the forward probability per window. A memory (204) stores a backward probability at a predetermined time calculated in previous iterative decoding and a backward probability calculation section (203) divides a data sequence into a plurality of windows and calculates the backward probability per window using the backward probability stored in the memory (204) as the initial value in iterative decoding of this time. A likelihood calculation section (205) calculates likelihood information using the calculated forward probability and backward probability.

FIG.3

**Description**

Technical Field

The present invention relates to a decoding apparatus and a decoding method, and is suitable for application in, for example, a decoding apparatus and a decoding method performing turbo decoding.

Background Art

In recent years, VSF-OFCDM(Variable Spreading Factor-Orthogonal Frequency and Code Division Multiplexing) draws attention as the most likely candidate for the scheme adopted for the fourth generation mobile communication. If VSF-OFCDM is employed, it will be possible to realize a maximum transmission rate of 100Mbps or more using bandwidth of about 50-100MHz. It is effective to employ turbo coding/decoding as an error correction scheme for such an ultra high-speed transmission scheme.

The turbo coding/decoding scheme is characterized by using both convolutional coding and interleaving for transmission data and performing iterative decoding upon decoding. It is well known that performing iterative decoding achieves excellent error correction capability not only for random errors, but for burst errors.

Here, an algorithm of turbo decoding will be explained briefly using equations. With turbo decoding, likelihood information $L(d_k)$ is calculated, and calculated likelihood information $L(d_k)$ is compared with a threshold value "0." As a result of the comparison, when likelihood information $L(d_k)$ is "0" or more, a hard decision is made that the systematic bit $d_k = 1$ transmitted at time k. When likelihood information $L(d_k)$ is less than "0, " a hard decision is made that the systematic bit $d_k = 0$ transmitted at time k.

Here, likelihood information $L(d_k)$ will be explained. Likelihood information $L(d_k)$ can be represented by the following equation using probability $\lambda_k$ that is defined as a product of forward probability $\alpha_k$ and backward probability $\beta_k$.

(Equation 1)

$$L(d_k) = \log \frac{\sum_m \lambda_k^1(m)}{\sum_m \lambda_k^0(m)} \quad \dots (1)$$

(Equation 2)

$$\lambda_k^i = \alpha_k(m) \cdot \beta_k(m) \quad \dots (2)$$

m is the state in a state transition trellis. Forward probability $\alpha_k$ and backward probability $\beta_k$ can be represented by the following equations respectively.

(Equation 3)

$$\alpha_k(m) = \frac{\sum_{m'} \sum_{i=0}^{1} \gamma_i(R_k, m', m) \alpha_{k-1}(m')}{\sum_m \sum_{m'} \sum_{i=0}^{1} \gamma_i(R_k, m', m) \alpha_{k-1}(m')} \quad \dots (3)$$

(Equation 4)

$$\beta_k(m) = \frac{\sum_{m'}\sum_{i=0}^{1}\gamma_i(R_{k+1},m',m)\beta_{k+1}(m')}{\sum_{m}\sum_{m'}\sum_{i=0}^{1}\gamma_i(R_{k+1},m,m')\alpha_k(m')} \quad \dots (4)$$

m' is also the state in a state transition trellis, and a transition probability $\gamma_i$ can be represented by the following equation.
(Equation 5)

$$\gamma_i(R_k,m',m) = p(R_k/d_k = i, S_k = m, S_{k-1} = m')$$
$$\cdot q(d_k = i/S_k = m, S_{k-1} = m') \cdot \pi(S_k = m/S_{k-1} = m') \quad \dots (5)$$

Here, $R_k$ is an input to a decoder at time k, and $p(\cdot/\cdot)$ is the transition probability of the discrete Gaussian memoryless transmission path. In addition, q corresponds to 0 or 1, and n represents a state transition probability of the trellis.

With turbo decoding, information bit $d_k$ is decoded by performingtheabove-notedcalculation,which,however, requires an enormous memory capacity. Then, a method called the sliding window method is considered.

Using this sliding window method makes possible considerable reduction in memory capacity. Turbo decoding processing procedures are, as described above, generally divided into the calculation of forward probability $\alpha$ (hereinafter referred to as "A calculation"), the calculation of backward probability $\beta$ (hereinafter referred to as "B calculation") and the calculation of likelihood information L ($d_k$) . The sliding window method is a method that effectively performs the A calculation and B calculation.

In the following, the sliding window method will be explained. The sliding window method divides all sequences of data into predetermined window units, provides a training interval for each window and calculates the backward probability, which must be calculated from the end of the sequences, from the middle of the sequences. According to this sliding window method, it is only necessary to store the backward probability on a per window basis, so that it is possible to considerably reduce memory capacity, compared to the case of storing all backward probabilities of times k to 1.

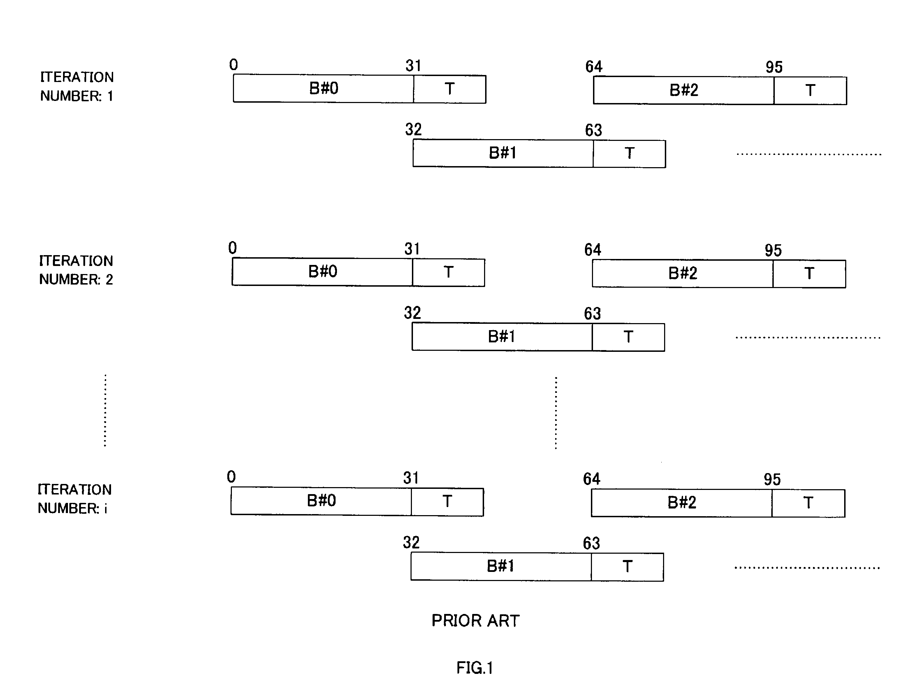

Here, more specifically, the sliding window method in case of performing the B calculation will be explained with reference to an accompanying drawing. FIG.1 is a pattern diagram conceptually showing repetition processing of conventional B calculation. Here, an explanation will be provided making the window size 32 and using three windows for ease of explanation. In this figure, the window at time 0-31 is B#0, the window at time 32-63 is B#1 and the window at time 64-95 is B#2. In addition, since the B calculation performs the calculation in backward direction in time, the training interval is put at the last time of each window and generally is four or five times longer than the constraint length.

Repetition processing of conventional B calculation initializes the initial value of each training interval to "0" for each iterative decoding and performs calculation using reliability information of each window obtained in previous decoding processing.

Non-Patent Document 1: Claude Berrou, "Near Optimum Error Correcting Coding And Decoding: Turbo-Codes," IEEE Trans. On Communications, Vol.44, No10, Oct. 1996.

Disclosure of Invention

Problems to be Solved by the Invention

However, since conventional sliding window method has a long training interval, there is a problem that the calculation amount and memory capacity of a turbo decoder are large. In addition, since the length of the training interval is fixed, there is a possibility that deterioration of characteristic worsens as the coding rate increases, and there is a problem that the training interval must be long in order to maintain the characteristic.

It is therefore an object of the present invention to provide a decoding apparatus and a decoding method that reduce the calculation amount and memory capacity and prevent deterioration of characteristic at high coding rates.

Means for Solving the Problems

The decoding apparatus of the present invention employs a configuration having: a backward probability calculation section that divides a data sequence into a plurality of windows and calculates a backward probability per window using a backward probability at a predetermined time calculated in previous iterative decoding as an initial value in iterative decoding of this time; a storage section that stores the backward probability at predetermined time calculated by the backward probability calculation section; and a likelihood calculation section that calculates likelihood information using the backward probability calculated by the backward probability calculation section.

Advantageous Effect of the Invention

With the present invention, the backward probability is calculated using the backward probability at a predetermined time calculated in previous iterative decoding as the initial value for iterative decoding of this time, so that characteristic can be improved even when the training interval is short, and it is therefore possible to reduce the calculation amount and memory capacity and prevent deterioration of characteristic at high coding rates.

Brief Description of the Drawings

FIG.1 is a pattern diagram conceptually showing the repetition processing of conventional B calculation;
FIG.2 is a block diagram showing the configuration of the turbo decoder according to Embodiment 1 of the present invention;
FIG.3 is a block diagram showing the internal configuration of the element decoder;
FIG.4 is a pattern diagram conceptually showing the repetition processing of B calculation according to Embodiment 1 of the present invention;
FIG.5 is a diagram showing the decoding characteristic of the turbo decoder according to Embodiment 1 of the present invention; and
FIG. 6 is a pattern diagram conceptually showing the repetition processing of B calculation according to Embodiment 2 of the present invention.

Best Mode for Carrying Out the Invention

Embodiments of the present invention will be explained below in detail with reference to the accompanying drawings.

(Embodiment 1)

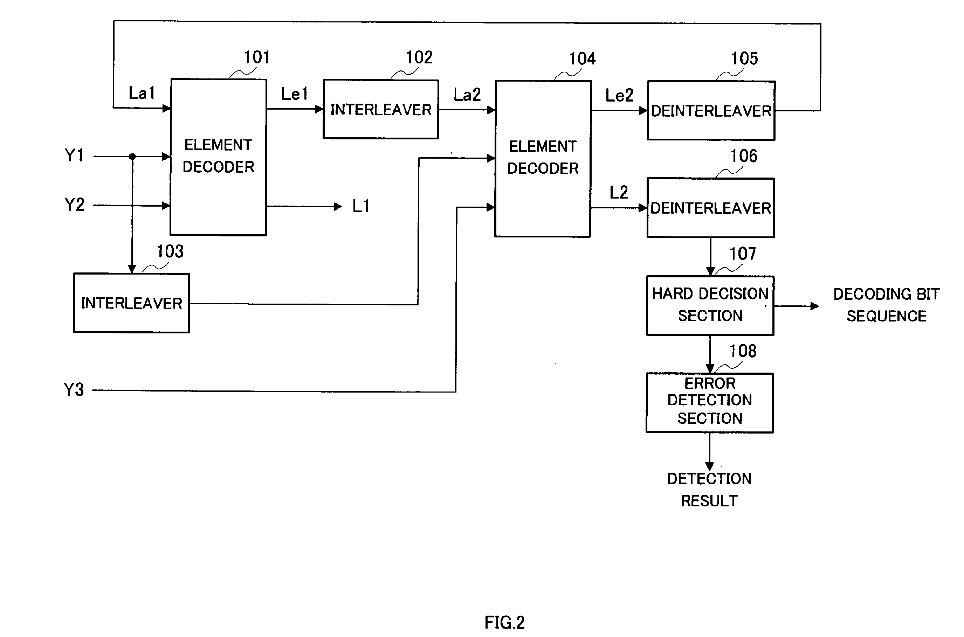

FIG.2 is a block diagram showing a configuration of a turbo decoder according to Embodiment 1 of the present invention. In this figure, element decoder 101 executes decoding processing on systematic bit sequence Y1 and parity bit sequence Y2 with a priori value La1, which is reliability information transmitted from deinterleaver 105, and outputs external value Le1 to interleaver 102. The external value indicates the increment of reliability by the element decoder.

Interleaver 102 rearranges external value Le1 output from element decoder 101 and outputs the result to element decoder 104 as a priori value La2. Incidentally, decoding is not performed at element decoder 104 in the first iteration and therefore "0" is substituted for the a priori value.

Element decoder 104 receives as input a sequence in which systematic bit sequences Y1 is rearranged at interleaver 103, parity bit sequence Y3 and a priori value La2, performs decoding processing and outputs external value Le2 to deinterleaver 105.

Deinterleaver 105 performs the operation of undoing the rearrangement by the interleaver upon external value Le2 to restore the rearrangement by the interleaver and outputs the result to element decoder 101 as a priori value La1. By this means, iterative decoding is performed. After iterative decoding is performed from several times to over ten times, element decoder 104 calculates posteriori value L2, which is defined as the logarithmic posteriori probability ratio, and outputs the calculation result to deinterleaver 106. Deinterleaver 106 deinterleaves the calculation result output from element decoder 104 and outputs the deinterleaved sequences to hard decision section 107.

Hard decision section 107 performs hard decision with the deinterleaved sequences, thereby outputting decoded bit sequences. Error detection section 108 performs error detection with the decoded bit sequences and outputs the detection result.

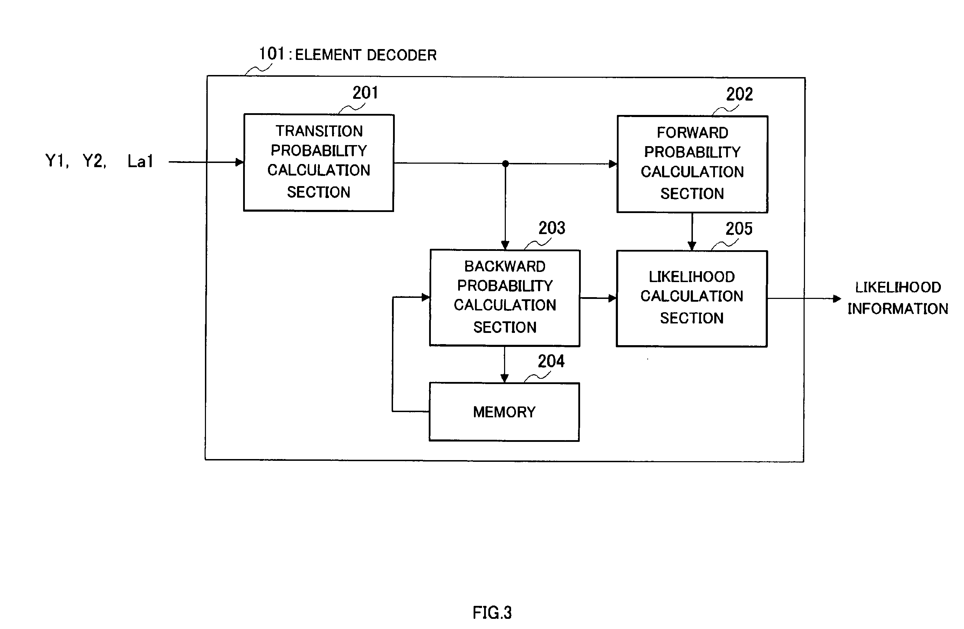

FIG.3 is a block diagram showing the internal configuration of element decoder 101. Assume that element decoder 104 has the same internal configuration as element decoder 101. Assume that decoding operation described below is performed in a window basis of a predetermined size.

First, systematic bit Y1, parity bit Y2 and a priori value La1 obtained from previous decoding result are input to transition probability calculation section 201, and transition probability γ is calculated. The calculated transition probability γ is output to forward probability calculation section 202 and backward probability calculation section 203.

Forward probability calculation section 202 performs the calculation of the above equation (3) with respect to the data sequence divided for per window using transition probability γ output from transition probability calculation section 201 and calculates forward probability $\alpha_k(m)$. The calculated $\alpha_k(m)$ is output to likelihood calculation section 205.

Backward probability calculation section 203 performs the calculation (B calculation) of the above equation (4) with respect to data sequence divided per window using transition probability γ output from transition probability calculation section 201 and a value described below that is stored in memory 204, which will be described later, and calculates backward probability $\beta_k(m)$. The calculated backward probability $\beta_k(m)$ is output to likelihood calculation section 205. In addition, backward probability that is used as initial value for the next iterative decoding is output to memory 204.

Memory 204 temporarily stores the backward probability of a predetermined time that is output from backward probability calculation section 203 and, when backward probability calculation section 203 performs iterative decoding, outputs the stored backward probability of a predetermined time in previous decoding to backward probability calculation section 203. The predetermined time corresponds to the time at which the calculation starts in each window, in the next iterative decoding.

Likelihood calculation section 205 performs the calculation of the above equation (1) using forward probability $\alpha_k(m)$ output from forward probability calculation section 202 and backward probability $\beta_k(m)$ output from backward probability calculation section 203 and calculates likelihood information.

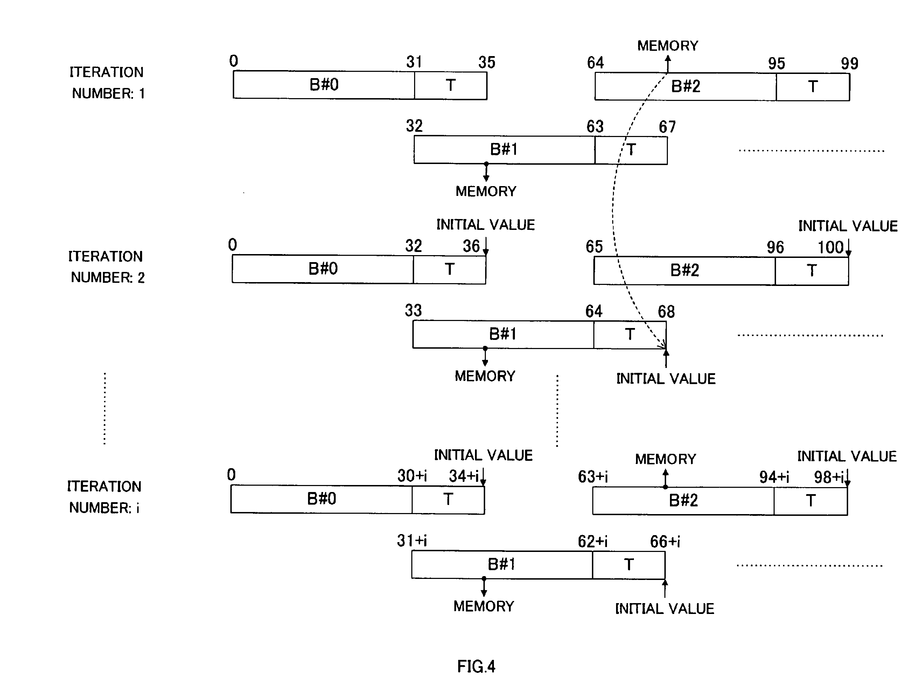

Next, the sliding window method when B calculation is performed by a turbo decoder will be explained. FIG.4 is a pattern diagram conceptually showing repetition processing of B calculation according to Embodiment 1 of the present invention. Here, an explanation will be provided making the window size 32 and using three windows for ease of explanation. In this figure, in iteration number 1, the window of time 0-31 is B#0, the window of time 32-63 is B#1 and the window of time 64-95 is B#2. In addition, the training interval has a size of four and is put at the last time of each window.

In the B calculation in iteration number 1, the calculation starts from the training interval of each window and proceeds in backward direction from higher time. Then, the backward probability of time 36 of window B#1 is stored in memory 204 and the backward probability of time 68 of window B#2 is stored in memory 204.

In iteration number 2, the backward probability of time 36 stored in memory 204 in iteration number 1 is made the initial value of the training interval of window B#0 and the backward probability of time 68 stored in memory 204 is made the initial value of the training interval of window B#1. Thus, by using the backward probability obtained in previous decoding as the initial value of this time, it is possible to consider that previous decoding processing correlates to the training interval of this time and improve decoding accuracy.

In addition, in iteration number 2, the window size of window B#0 is made larger by one and the time is made 0-32. The time of window B#1 and window B#2 is brought forward by one, and the time of window B#1 is 33-64 and time of window B#2 is 65-96. In line with this, the time of the training interval also changes.

Assuming that the iteration number is i and generally represented, the B calculation is performed using the backward probability at a predetermined time of iteration number (i-1) as the initial value of the training interval of each window, expanding window B#0 backward by time i and shifting window B#1, B#2 ... backward by time i.

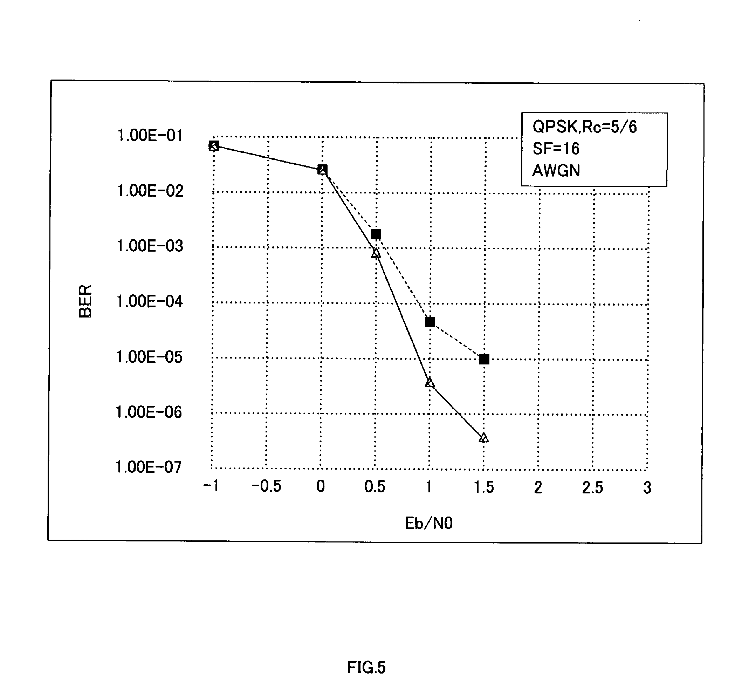

Next, decoding characteristics when the above sliding window method is used will be explained. FIG.5 is a diagram showing decoding characteristics of a turbo decoder according to Embodiment 1 of the present invention. In this figure, the vertical axis is the bit error rate (BER) and the horizontal axis is Eb/NO. In addition, the solid line indicates decoding characteristics of the turbo decoder according to the embodiment and the dotted line indicates decoding characteristic of a conventional turbo decoder. Simulation parameters are as follows:

Modulation scheme (Data): QPSK
Coding rate: 5/6
Spreading factor: 16
Channel model: AWGN (Additive White Gaussian Noise)
Training interval: 32

As can be seen from this figure, the decoding characteristic of the turbo decoder of the embodiment indicated by the solid line is excellent. Here, good decoding characteristic can be obtained although the coding rate is set high at 5/6, so that it is possible to prevent deterioration of characteristic even when the coding rate is high.

Here, comparison is made with a case when a training interval is 32, however, as described above, the same decoding characteristic as the solid line can be achieved even when the training interval is 4, so that it is possible to prevent deterioration even when the training interval is short.

Thus, according to the embodiment, the backward probability of a predetermined time of each window in previous decoding is made the initial value of the training interval of this time, and the window position is shifted backward each time decoding is iterated, so that the accuracy of the initial value improves every iteration, and it is possible to reduce the training interval and reduce the calculation amount and memory capacity. In addition, it is possible to prevent deterioration of characteristics at high coding rates.

(Embodiment 2)

A case will be described with Embodiment 2 of the present invention where the training interval is not provided. The configuration of the turbo decoder of the embodiment is the same as that of FIG.2, and the configuration of the element decoder is the same as that of FIG.3, and, therefore, FIG 2 and FIG.3 are incorporated by reference and detailed explanations thereof are omitted.

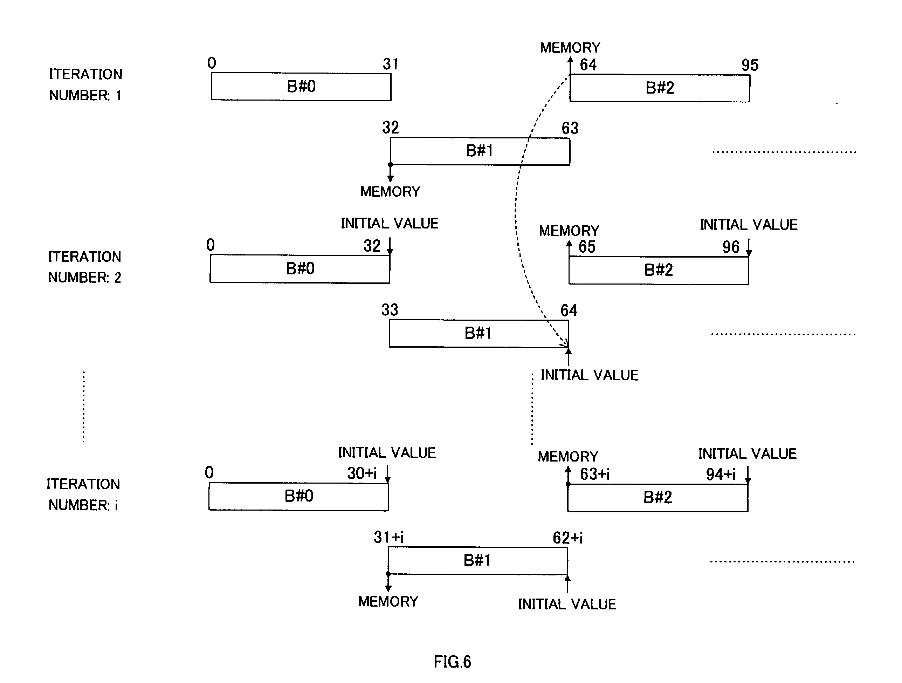

FIG.6 is a pattern diagram conceptually showing the repetition processing of the B calculation according to Embodiment 2 of the present invention. Here, an explanation will be provided making the window size 32 and using three windows for ease of explanation. In this figure, in iteration number 1, the window of time 0-31 is B#0, the window of time 32-63 is B#1 and the window of time 64-95 is B#2.

In the B calculation in iteration number 1, the calculation is performed from higher time to the backward direction, and the backward probability at time 32 of window B#1 is stored in memory 204 and the backward probability at time 64 of window B#2 is stored in memory 204.

In iteration number 2, the backward probability at time 32 stored in memory 204 in iteration number 1 is made the initial value of the training interval of window B#0 and the backward probability at time 64 stored in memory 204 is made the initial value of the training interval of window B#1. In addition, the window size of window B#0 is made larger by one and the time is made 0-32. The time of window B#1 and window B#2 is brought forward by one, and the time of window B#1 are 33-64 and the time of window B#2 is 65-96.

Assuming that iteration number is i and generally represented, the B calculation is performed using the backward probability at a predetermined time in iteration number (i-1) as the initial value at the start of operation in each window, expanding window B#0 backward by time i and shifting window B#1, B#2 ... backward by time i.

Decoding characteristics when the above sliding window method is used shows substantially the same characteristic as that indicated by the solid line of FIG.5 of Embodiment 1, and it is possible to prevent deterioration of characteristic without providing the training interval.

Thus, according to this embodiment, the backward probability of a predetermined time in each window in previous decoding is made the initial value of the training interval of this time and the window position is shifted backward each time decoding is iterated, so that the accuracy of the initial value improves every iteration, it is possible to prevent deterioration of characteristics without providing a training interval and reduce the calculation amount and memory capacity.

Although cases of backward probability calculation have been described with the above embodiments, the present invention is by no means limited to this, and it is equally possible to calculate the forward probability using the forward probability of a predetermined time calculated in previous iterative decoding as the initial value in iterative decoding of this time. By this means, it is possible to reduce the training interval used in forward probability calculation and reduce the calculation amount and memory capacity.

In addition, regarding the amount of shifting the window, cases have been described above with the above embodiments where, when the iteration number is i, a shift is applied in proportion of time i. However, the present invention by no means limited to this, and it is equally possible to make the shift amount (i-1) $\times$ j . Note that j is a positive number excluding 0.

A first aspect of the present invention provides a decoding apparatus having: a backward probability calculation section that divides a data sequence into a plurality of windows and calculates a backward probability per window using the backward probability at a predetermined time calculated in previous iterative decoding as an initial value in iterative decoding of this time; a storage section that stores the backward probability at a predetermined time calculated by the backward probability calculation section; and, a likelihood calculation section that calculates likelihood information using the backward probability calculated by the backward probability calculation section.

A second aspect of the present invention provides the decoding apparatus of the above-described aspect in which the backward probability calculation section shifts a window position backward in accordance with a number of iterations of decoding and calculates the backward probability.

With these configurations, by calculating the backward probability per window using the backward probability at a predetermined time calculated in previous iterative decoding as the initial value in iterative decoding of this time, the accuracy of the initial value improves as the number of iterations grows, so that it is possible to reduce the training interval and reduce the calculation amount and memory capacity. In addition, it is possible to prevent deterioration of characteristics at high coding rates.

A third aspect of the present invention provides the decoding apparatus of the above-described aspect in which the storage section stores the backward probability at the time next iterative decoding begins in accordance with the backward shift of the window position by the backward probability calculation section.

According to this configuration, in accordance with the backward shift of the window position by the backward probability calculation section, the storage section stores the backward probability at the time the next iterative decoding begins --that is to say, the initial value-- so that, even when the window shifts and the calculation start point changes every iteration, the initial value of high accuracy is used, and it is possible to reduce the training interval and reduce the calculation amount and memory capacity.

A fourth aspect of the present invention provides the decoding apparatus having: a forward probability calculation section that divides a data sequence into a plurality of windows and calculates a forward probability per window using the forward probability at a predetermined time calculated in previous iterative decoding as an initial value in iterative decoding of this time; a storage section that stores the forward probability at a predetermined time calculated by the forward probability calculation section; and, a likelihood calculation section that calculates likelihood information using the forward probability calculated by the forward probability calculation section.

According to this configuration, by calculating a forward probability per window using the forward probability of a predetermined time calculated in previous iterative decoding as the initial value in iterative decoding of this time, the accuracy of the initial value improves as a number of iteration grows, so that it is possible to reduce a training interval and reduce the calculation amount and memory capacity. In addition, it is possible to prevent deterioration of characteristics at high coding rates.

A fifth aspect of the present invention provides a decoding method in which a data sequence is divided into a plurality of windows and a backward probability is calculated per window using the backward probability at predetermined time calculated in previous iterative decoding as an initial value of iterative decoding of this time.

With this method, by calculating the backward probability per window using the backward probability at a predetermined time calculated in previous iterative decoding as the initial value in iterative decoding of this time, the accuracy of the initial value improves as the number of iterations grows, so that it is possible to reduce the training interval and reduce the calculation amount and memory capacity. In addition, it is possible to prevent deterioration of characteristics at high coding rates.

The present application is based on Japanese Patent Application No.2003-402218, filed on December 1, 2003, the entire content of which is expressly incorporated by reference herein.

Industrial Applicability

The decoding apparatus of the present invention calculates a backward probability using the backward probability at a predetermined time calculated in previous iterative decoding as initial value in iterative decoding of this time, thereby providing an advantage of reducing the calculation amount and memory capacity and preventing deterioration of characteristics at high coding rates, and is applicable to a turbo decoder and so forth.

**Claims**

1. A decoding apparatus comprising:

   a backward probability calculation section that divides a data sequence into a plurality of windows and calculates backward probability per window using a backward probability at a predetermined time calculated in previous iterative decoding as an initial value in iterative decoding of this time;
   a storage section that stores the backward probability at the predetermined time calculated by the backward probability calculation section; and
   a likelihood calculation section that calculates likelihood information using the backward probability calculated by the backward probability calculation section.

2. The decoding apparatus according to claim 1, wherein the backward probability calculation section shifts a window position backward in accordance with a number of iterations of decoding and calculates the backward probability.

3. The decoding apparatus according to claim 2, wherein the storage section stores a backward probability at a time next iterative decoding begins in accordance with the backward shift of the window position by the backward probability calculation section.

4. A decoding apparatus comprising:

   a forward probability calculation section that divides a data sequence into a plurality of windows and calculates a forward probability per window using the forward probability at a predetermined time calculated in previous iterative decoding as an initial value in iterative decoding of this time;
a storage section that stores forward probability at the predetermined time calculated by the forward probability calculation section; and
a likelihood calculation section that calculates likelihood information using the forward probability calculated by the forward probability calculation section.

5. A decoding method comprising dividing a data sequence into a plurality of windows and calculating a backward probability per window using a backward probability at a predetermined time calculated in previous iterative decoding as an initial value of iterative decoding of this time.

ITERATION
NUMBER: 1

| 0 | | 31 | | | 64 | | 95 | |
|---|---|---|---|---|---|---|---|---|
| | B#0 | | T | | | B#2 | | T |

| 32 | | 63 | |
|---|---|---|---|
| | B#1 | | T |

...................................

ITERATION
NUMBER: 2

| 0 | | 31 | | | 64 | | 95 | |
|---|---|---|---|---|---|---|---|---|
| | B#0 | | T | | | B#2 | | T |

| 32 | | 63 | |
|---|---|---|---|
| | B#1 | | T |

...................................

ITERATION
NUMBER: i

| 0 | | 31 | | | 64 | | 95 | |
|---|---|---|---|---|---|---|---|---|
| | B#0 | | T | | | B#2 | | T |

| 32 | | 63 | |
|---|---|---|---|
| | B#1 | | T |

...................................

PRIOR ART

FIG.1

FIG.2

EP 1 677 423 A1

101 : ELEMENT DECODER

Y1, Y2, La1 →

```
┌─────────────────────────────────────────────────────────────────┐
│                                                                   │
│         201                              202                      │
│    ┌──────────────┐                 ┌──────────────┐              │
│    │  TRANSITION  │                 │   FORWARD    │              │
│    │ PROBABILITY  │─────────┬──────▶│ PROBABILITY  │              │
│    │ CALCULATION  │         │       │ CALCULATION  │              │
│    │   SECTION    │         │       │   SECTION    │              │
│    └──────────────┘         │       └──────────────┘              │
│                             │                 │                   │
│                         203 ▼               205 ▼                 │
│    ┌──────────────┐   ┌──────────────┐   ┌──────────────┐        │
│    │              │   │   BACKWARD   │   │  LIKELIHOOD  │         │
│    │              ├──▶│ PROBABILITY  ├──▶│ CALCULATION  │─────────▶ LIKELIHOOD
│    │              │   │ CALCULATION  │   │   SECTION    │           INFORMATION
│    │              │   │   SECTION    │   │              │         │
│    └──────────────┘   └──────────────┘   └──────────────┘        │
│           ▲                 │                                     │
│           │             204 ▼                                     │
│           │           ┌──────────────┐                           │
│           └───────────│    MEMORY    │                           │
│                       └──────────────┘                           │
│                                                                   │
└─────────────────────────────────────────────────────────────────┘
```

FIG.3

EP 1 677 423 A1

EP 1 677 423 A1

ITERATION
NUMBER: 1

MEMORY

0    31    35         64              95    99
| B#0 | T |         | B#2 | T |

32              63    67
| B#1 | T |

MEMORY

INITIAL VALUE                    INITIAL VALUE

ITERATION
NUMBER: 2

0    32    36         65              96    100
| B#0 | T |         | B#2 | T |

33              64    68
| B#1 | T |

MEMORY         INITIAL VALUE

INITIAL VALUE         MEMORY    INITIAL VALUE

ITERATION
NUMBER: i

0    30+i  34+i       63+i            94+i  98+i
| B#0 | T |         | B#2 | T |

31+i            62+i  66+i
| B#1 | T |

MEMORY    INITIAL VALUE

FIG.4

FIG.5

ITERATION
NUMBER: 1

```
0                    31
┌──────────────────┐
│       B#0        │
└──────────────────┘
```

MEMORY

```
      64                 95
    ┌──────────────────┐
    │       B#2        │
    └──────────────────┘
```

```
 32                  63
┌──────────────────┐
│       B#1        │ . . . . . . . . . . . . . . . .
└──────────────────┘
```

MEMORY

INITIAL VALUE

ITERATION
NUMBER: 2

```
0                    32
┌──────────────────┐
│       B#0        │
└──────────────────┘
```

MEMORY        INITIAL VALUE

```
      65                 96
    ┌──────────────────┐
    │       B#2        │
    └──────────────────┘
```

```
 33                  64
┌──────────────────┐
│       B#1        │ . . . . . . . . . . . . . . . .
└──────────────────┘
```

INITIAL VALUE

ITERATION
NUMBER: i

INITIAL VALUE

```
0                  30+i
┌──────────────────┐
│       B#0        │
└──────────────────┘
```

MEMORY        INITIAL VALUE

```
    63+i               94+i
    ┌──────────────────┐
    │       B#2        │
    └──────────────────┘
```

```
 31+i                62+i
┌──────────────────┐
│       B#1        │ . . . . . . . . . . . . . . . .
└──────────────────┘
```

MEMORY        INITIAL VALUE

FIG.6

## EP 1 677 423 A1

**INTERNATIONAL SEARCH REPORT**

| International application No. |
|---|
| PCT/JP2004/017284 |

**A. CLASSIFICATION OF SUBJECT MATTER**
Int.Cl⁷ H03M13/29

According to International Patent Classification (IPC) or to both national classification and IPC

**B. FIELDS SEARCHED**

Minimum documentation searched (classification system followed by classification symbols)
Int.Cl⁷ H03M13/00-13/53

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2004 |
| Kokai Jitsuyo Shinan Koho | 1971-2004 | Toroku Jitsuyo Shinan Koho | 1994-2004 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | JP 2002-314437 A (NEC Corp.),<br>25 October, 2002 (25.10.02),<br>Full text; all drawings<br>(Family: none) | 1,4,5<br>2,3 |
| A | Claude Berrou and Alain Glavieux, Near Optimum Error Correcting Coding And Decoding: Turbo-Codes, IEEE Transactions on Communications, October 1996, Vol.44, No.10, pages 1261 to 1271 | 1-5 |
| A | Kazuo OBUCHI et al., "Turbo Fugo ni okeru Sub-log-MAP no Kairo Kibo Sakugen Hoshiki", The Institute of Electronics, Information and Communication Engineers Gijutsu Kenkyu Hokoku (CS99-48), 25 June, 1999 (25.06.99), Vol.99, No.140, pages 1 to 6 | 1-5 |

| ☒ | Further documents are listed in the continuation of Box C. | ☐ | See patent family annex. |
|---|---|---|---|

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search<br>06 January, 2005 (06.01.05) | Date of mailing of the international search report<br>25 January, 2005 (25.01.05) |
|---|---|
| Name and mailing address of the ISA/<br>Japanese Patent Office | Authorized officer |
| Facsimile No. | Telephone No. |

Form PCT/ISA/210 (second sheet) (January 2004)

15

**INTERNATIONAL SEARCH REPORT**

| | International application No. |
|---|---|
| | PCT/JP2004/017284 |

C (Continuation). DOCUMENTS CONSIDERED TO BE RELEVANT

| Category* | Citation of document, with indication, where appropriate, of the relevant passages | Relevant to claim No. |
|---|---|---|
| A | JP 2001-267938 A (Texas Instruments Inc.),<br>28 September, 2001 (28.09.01),<br>Par. Nos. [0024] to [0025]<br>& EP 1122890 A2      & US 2001/0046269 A1 | 1-5 |
| A | JP 2002-367291 A (Fujitsu Ltd.),<br>20 December, 2002 (20.12.02),<br>Par. Nos. [0143] to [0151]<br>& EP 1267345 A1      & US 2003/0026028 A1<br>& CN 1391220 A | 1-5 |

Form PCT/ISA/210 (continuation of second sheet) (January 2004)